# EUROPÄISCHE PATENTSCHRIFT

(11) **EP 3 913 716 B1**
(45) Veröffentlichungstag und Bekanntmachung des Hinweises auf die Patenterteilung: **17.12.2025**
(21) Anmeldenummer: 21165582.4
(22) Anmeldetag: 29.03.2021
(51) Int. Cl.: H01M 10/052, H01M 10/653, H01M 10/655, H01M 50/20, H01M 50/209, H01M 50/258, H01M 50/296, H01M 50/55

(54) **BATTERIEMODUL MIT EINER MEHRZAHL AN BATTERIEZELLEN UND VERFAHREN ZUR HERSTELLUNG EINES SOLCHEN**
BATTERY MODULE WITH A PLURALITY OF BATTERY CELLS AND METHOD OF MANUFACTURING SUCH A MODULE
MODULE DE BATTERIE DOTÉ D'UNE PLURALITÉ D'ÉLÉMENTS DE BATTERIE ET PROCÉDÉ DE FABRICATION D'UN TEL MODULE

(30) Priorität: 20.05.2020 DE 102020206339
(43) Veröffentlichungstag der Anmeldung: 24.11.2021
(73) Patentinhaber: Robert Bosch GmbH, 70442 Stuttgart (DE)
(72) Erfinder: Glemser, Ralph, 74336 Brackenheim (DE); Gottwald, Frank, 71287 Weissach (DE)

(56) Entgegenhaltungen:
- WO-A2-2013/138380
- DE-A1- 102014 001 238
- DE-A1- 102015 208 159
- DE-B3- 102016 203 129

## Beschreibung

### Stand der Technik

Die Erfindung geht aus von einem Batteriemodul mit einer Mehrzahl an Batteriezellen nach Gattung des unabhängigen Anspruchs. Gegenstand der vorliegenden Erfindung ist auch ein Verfahren zur Herstellung eines solchen. Aus dem Stand der Technik ist bekannt, dass Batteriemodule aus einer Mehrzahl an einzelnen Batteriezellen bestehen können, welche seriell und/oder parallel elektrisch leitend miteinander verschaltet sein können, so dass die einzelnen Batteriezellen zu dem Batteriemodul zusammengeschaltet sind. Weiterhin werden solche Batteriemodule zu Batterien bzw. Batteriesystemen zusammengeschaltet. Zudem weisen solche Batteriemodule häufig Schalteinrichtungen wie bspw. ein Relais auf, die eine Spannungsfreiheit üblicherweise am positiven Pol des Batteriemoduls regeln sollen. Solche Schalteinrichtungen führen somit den maximalen Strom des jeweiligen Batteriemoduls und erzeugen grundsätzlich vergleichbar viel Wärme. Aus dem Stand der Technik ist bekannt, diese abzugebende Wärme beispielsweise über eine Oberfläche der Schalteinrichtung oder auch eines Stromleiters, der die Schalteinrichtung mit einer Batteriezelle elektrisch leitend verbindet, mittels Konvektion an eine Umgebungsluft des Batteriemoduls abzugeben. DE2016203129B3 offenbart eine Batterie für ein Kraftfahrzeug mit einer Mehrzahl von prismatischen Batteriezellen und mit wenigstens einem Verbindungselement , welches einen elektrischen Pol einer ersten Batteriezelle mit einem elektrischen Pol wenigstens einer zweiten Batteriezelle elektrisch verbindet. Die Batteriezellen sind in einem Gehäuse der Batterie aufgenommen. Hierbei ist zwischen dem wenigstens einen Verbindungselement und einem Gehäusebauteil des Gehäuses ein Wärmeübertragungselement angeordnet. DE102014001238A1 offenbart eine Batterie mit Batteriezellen in einem Gehäuse, wobei ein Verbindungselement zwischen dem Anschlusspol und der Batteriezelle ein thermisches Widerstandselement mit einem erhöhten thermischen Widerstand aufweist, derart, dass entstehende und/ oder vorhandene Wärme im wesentlichen in Gegenrichtung zur Batteriezelle fließt. Ein Strommesselement, z.B. ein Relais kann zwischen der Batteriezelle und dem Anschlusspol befindlich sein, so dass bei Überschreiten eines Stromgrenzwertes das elektrische Trennelement den Stromfluss unterbricht.

### Offenbarung der Erfindung

Ein Batteriemodul mit einer Mehrzahl an Batteriezellen mit den Merkmalen des unabhängigen Anspruchs bietet den Vorteil, dass auf zuverlässige Weise eine Entwärmung einer Schalteinrichtung des Batteriemoduls zur Verfügung gestellt werden kann.

Dazu wird ein Batteriemodul mit einer Mehrzahl an Batteriezellen zur Verfügung gestellt. Die Batteriezellen sind dabei insbesondere als Lithium-Ionen-Batteriezellen ausgebildet. Weiterhin sind die Batteriezellen jeweils elektrisch leitend seriell und/oder parallel miteinander verschaltet. Dazu können die Batteriezellen jeweils einen ersten Spannungsabgriff, insbesondere einen positiven Spannungsabgriff, und einen zweiten Spannungsabgriff, insbesondere einen negativen Spannungsabgriff, aufweisen, die untereinander mittels Zellverbindern elektrisch leitend verbunden sind, sodass eine elektrisch serielle und/oder parallele Verschaltung ausgebildet ist.

Das Batteriemodul umfasst zudem eine Schalteinrichtung mit einem ersten Anschluss und mit einem zweiten Anschluss. Ein erstes elektrisch leitend ausgebildetes Verbindungselement verbindet den ersten Anschluss elektrisch leitend mit einem Spannungsabgriff einer endständig angeordneten Batteriezelle. Insbesondere ist der Spannungsabgriff der endständig angeordneten Batteriezelle dabei ein erster Spannungsabgriff bzw. positiver Spannungsabgriff. Ein zweites elektrisch leitend ausgebildetes Verbindungselement verbindet den zweiten Anschluss elektrisch leitend mit einem Spannungsabgriff des Batteriemoduls. Insbesondere ist der Spannungsabgriff des Batteriemoduls dabei ein positiver Spannungsabgriff.

Dabei sind das erste Verbindungselement und/oder das zweite Verbindungselement wärmeleitend in einer Aufnahme des Gehäuses des Batteriemoduls aufgenommen.

Durch die in den abhängigen Ansprüchen aufgeführten Maßnahmen sind vorteilhafte Weiterbildungen und Verbesserungen der im unabhängigen Anspruch angegebenen Vorrichtung möglich.

An dieser Stelle sei angemerkt, dass mit einer erfindungsgemäßen Ausführungsform des Batteriemoduls insbesondere auch der positive Spannungsabgriff der endständig angeordneten Batteriezelle, welcher eine vergleichbar hohe thermische Belastung erfährt, zuverlässig entwärmt werden kann.

Insgesamt kann damit auch bei vergleichbar hohen Anforderungen an das Batteriemodul beispielsweise einem durchschnittlichen Dauerstrom von 200 A oder einem maximalen Strom von 600 A für 10 Sekunden eine zuverlässige Entwärmung der Schalteinrichtung und des positiven Spannungsabgriffs der endständig angeordneten Batteriezelle zur Verfügung gestellt werden. Somit kann eine maximale Temperatur an dem positiven Spannungsabgriff der endständig angeordneten Batteriezelle oder der Schalteinrichtung vergleichbar gering gehalten werden und insbesondere kann dadurch auch die Lebensdauer des gesamten Batteriemoduls erhöht werden.

Zweckmäßigerweise ist in der Aufnahme weiterhin ein wärmeleitend ausgebildetes Ausgleichsmaterial angeordnet. An dieser Stelle sei angemerkt, dass das Ausgleichsmaterial auch als Thermal Interface Material (TIM) bekannt ist. Insbesondere kann das Ausgleichsmaterial auch elektrisch isolierend ausgebildet sein, um eine elektrische Isolation auszubilden. Insbesondere kann dieses Material bevorzugt ausgewählt sein aus einem Epoxid oder einem Silikon oder einem Polyurethan (PU).

Insbesondere kann das Ausgleichselement vor einer Anordnung des ersten Verbindungselements oder des zweiten Verbindungselements in der Aufnahme aufgenommen sein. Durch ein Einführen des ersten Verbindungselements oder des zweiten Verbindungselements kann sich das Ausgleichselement in der Aufnahme verteilen und dadurch eine zuverlässige Wärmeübertragung ausbilden. Insbesondere ist das Ausgleichsmaterial elastisch oder plastisch verformbar ausgebildet.

Es ist vorteilhaft, wenn die Aufnahme an einer Seitenfläche des Gehäuses des Batteriemoduls angeordnet ist. Zudem könnte es auch vorteilhaft sein, wenn die Aufnahme an einer Bodenfläche des Gehäuses des Batteriemoduls ausgebildet ist. An dieser Stelle sei angemerkt, dass unter einer Bodenfläche die während eines ordnungsgemäßen Gebrauchs unten angeordnete Unterseite des Batteriemoduls verstanden sein sollen. Dementsprechend soll eine Seitenfläche senkrecht zu der Unterseite angeordnet sein.

Gemäß einem bevorzugten Aspekt der Erfindung umfasst die Aufnahme eine Öffnung. Insbesondere sei an dieser Stelle angemerkt, dass die Öffnung dazu ausgebildet ist, das erste Verbindungselement und/oder das zweite Verbindungselement in die Aufnahme einzuführen. Die Öffnung weist dabei eine Querschnittsfläche auf, welche senkrecht zu der Seitenfläche bzw. parallel zu der Bodenfläche angeordnet ist.

Bei einer an einer Seitenfläche des Gehäuses des Batteriemoduls ausgebildeten Aufnahme ist die Querschnittsfläche der Öffnung also senkrecht zu der Seitenfläche ausgebildet. An dieser Stelle sei angemerkt, dass bei einer an einer Seitenfläche des Gehäuses des Batteriemoduls ausgebildeten Aufnahme die Öffnung nicht an einer größten Seitenfläche der Aufnahme angeordnet ist. Mit anderen Worten ausgedrückt bedeutet dies, dass die Aufnahme im Vergleich zu ihrem Volumen eine vergleichbar kleine Öffnung aufweist. Insbesondere weist die Öffnung eine rechteckige Form auf, bei welcher die Länge um ein Vielfaches größer ist als die Breite. Selbstverständlich kann die Öffnung auch eine elliptische, ovale oder kreisrunde Form aufweisen.

Zudem sei an dieser Stelle bemerkt, dass zu einer Anordnung des ersten Verbindungselements oder des zweiten Verbindungselements in der Aufnahme das erste Verbindungselement bzw. das zweite Verbindungselement entlang der Seitenfläche parallel zu der Seitenfläche in die Aufnahme eingeführt wird. Mit anderen Worten ausgedrückt bedeutet dies, dass eine an einer Seitenfläche des Gehäuses des Batteriemoduls ausgebildete Aufnahme taschenförmig ausgebildet ist.

Bei einer an einer Bodenfläche des Gehäuses des Batteriemoduls ausgebildeten Aufnahme ist die Querschnittsfläche der Öffnung also parallel zu der Bodenfläche ausgebildet. An dieser Stelle sei angemerkt, dass bei einer an einer Bodenfläche des Gehäuses des Batteriemoduls ausgebildeten Aufnahme die Öffnung an einer größten Seitenfläche der Aufnahme angeordnet ist. Mit anderen Worten ausgedrückt bedeutet dies, dass die Aufnahme im Vergleich zu ihrem Volumen eine vergleichbar große Öffnung aufweist. Insbesondere weist die Öffnung eine rechteckige Form auf, bei welcher die Länge in etwa der Breite entspricht. Zudem sei an dieser Stelle bemerkt, dass zu einer Anordnung des ersten Verbindungselements oder des zweiten Verbindungselements in der Aufnahme das erste Verbindungselement bzw. das zweite Verbindungselement senkrecht zu der Bodenfläche in die Aufnahme eingeführt wird. Mit anderen Worten ausgedrückt bedeutet dies, dass eine an einer Bodenfläche des Gehäuses des Batteriemoduls ausgebildete Aufnahme als Vertiefung ausgebildet ist.

Bei den beiden genannten Ausführungsformen der Aufnahme können das erste Verbindungselement und/oder das zweite Verbindungselement jeweils von oben in einer Richtung senkrecht zu der Bodenfläche bzw. parallel zu der Seitenfläche in das Batteriemodul eingeführt werden. Insbesondere kann dabei eine Vorbaugruppe bestehend aus der Schalteinrichtung, dem ersten Verbindungselement und dem zweiten Verbindungselement ausgebildet werden, welche anschließend in das Batteriemodul eingeführt wird.

Besonders bevorzugt sind das erste Verbindungselement und das zweite Verbindungselement ausgebildet aus einem Material, welches ausgewählt ist aus Kupfer oder Aluminium oder Keramik. Dies bietet den Vorteil, dass eine besonders zuverlässige Wärmeabfuhr aufgrund einer vergleichbar hohen Wärmeleitfähigkeit zur Verfügung gestellt werden kann.

Es ist zweckmäßig, wenn das Batteriemodul weiterhin ein Halteelement umfasst, welches zwischen der Aufnahme und dem ersten Verbindungselement bzw. dem zweiten Verbindungselement angeordnet ist. Insbesondere kann das Halteelement aus einem polymeren Werkstoff ausgebildet sein. Es ist besonders vorteilhaft, wenn das Halteelement vor einer Anordnung des ersten Verbindungselements oder des zweiten Verbindungselements in der Aufnahme an dem ersten Verbindungselement bzw. an dem zweiten Verbindungselement angeordnet wird. Beispielsweise kann das Halteelement geklipst mit dem ersten Verbindungselement bzw. dem zweiten Verbindungselement verbunden werden. Es ist auch möglich, das Halteelement an das erste Verbindungselement bzw. das zweite Verbindungselement anzuspritzen. Das Halteelement erfüllt den besonderen Zweck, dass das erste Verbindungselement bzw. das zweite Verbindungselement von der Aufnahme beabstandet werden können, sodass elektrische Kurzschlüsse verhindert werden können. Weiterhin kann dadurch ein definierter Abstand ausgebildet werden, in welchem das Ausgleichsmaterial angeordnet ist. Das Halteelement dient insbesondere dazu Mindestabstände für Luft- und Kriechstreckenanforderungen auszubilden.

Erfindungsgemäss ist die Schalteinrichtung unmittelbar benachbart zu der endständig angeordneten Batteriezelle angeordnet. Die Batteriezellen sind erfindungsgemäss als prismatische Batteriezellen ausgebildet. Prismatische Batteriezellen weisen üblicherweise sechs Seitenflächen auf, wobei gegenüberliegende Seitenflächen jeweils im Wesentlichen parallel zueinander angeordnet und im Wesentlichen gleich groß ausgebildet sind. Unmittelbar benachbart zueinander angeordnete Seitenflächen sind dabei jeweils im Wesentlichen rechtwinklig zueinander angeordnet. Die Batteriezellen sind dabei in der Art angeordnet, dass diese bevorzugt mit ihren jeweils größten Seitenflächen in einer Längsrichtung des Batteriemoduls benachbart zueinander angeordnet sind. Die Schalteinrichtung ist hierbei insbesondere unmittelbar benachbart zu einer größten Seitenfläche einer in der Längsrichtung endständig angeordneten Batteriezelle angeordnet. An dieser Stelle sei noch bemerkt, dass endständig angeordnet auch elektrisch endständig angeordnet bedeuten kann. Eine endständige Anordnung bietet insbesondere den Vorteil, dass eine kurze elektrisch leitende Verbindung zwischen dem ersten Anschluss der Schalteinrichtung und dem Spannungsabgriff der endständigen Batteriezelle auszubilden ist.

Besonders bevorzugt ist es, wenn das Gehäuse des Batteriemoduls ein Temperierelement umfasst. Beispielsweise kann das Batteriemodul dazu, einen von Temperierfluid durchströmbaren Temperierraum ausbilden. Das Temperierelement ist dabei bevorzugt an einer Unterseite des Batteriemoduls angeordnet. Ferner kann das Temperierelement auch als Temperierplatte ausgebildet sein, welche zusätzlich zu dem Gehäuse angeordnet sein kann. Insbesondere können das Gehäuse des Batteriemoduls und/oder das Temperierelement bevorzugt aus Aluminium ausgebildet sein. Dadurch kann eine aktive Kühlung des Gehäuses des Batteriemoduls ausgebildet werden.

Vorteilhaft ist, wenn die Aufnahme unmittelbar benachbart zu dem Temperierelement angeordnet ist. Dadurch kann Wärme besonders effektiv an das Temperierelement übertragen werden. Insbesondere kann dadurch Wärme mittels des ersten Verbindungselements und des zweiten Verbindungselements zuverlässig an das Temperierelement übertragen werden.

Die Schaltervorrichtung kann bspw. als Halbleiterschalter, welche auch als Transistoren, Metalloxidhalbleiterfeldeffekttransistoren (MOSFETs) oder Bipolartransistoren mit isoliertem Gate (IGBTs) bekannt sind, ausgebildet sein. Bevorzugt ist die Schaltervorrichtung ein mechanisches Relais, in dem ein Kontakt durch eine elektromagnetische Kraft geöffnet und geschlossen werden kann.

Besonders vorteilhaft ist, dass mit einer erfindungsgemäßen Ausführungsform insbesondere innerhalb der Schalteinrichtung während des Betriebs erzeugte Wärme mittels des ersten Verbindungselements und des zweiten Verbindungselements über die jeweilige Aufnahme an das Gehäuse des Batteriemoduls abgeführt werden kann. Dadurch kann beispielsweise die Lebensdauer der Schalteinrichtung erhöht werden und/oder kann die Schalteinrichtung an vergleichbar höhere Anforderungen an das Batteriemodul insbesondere hinsichtlich des maximalen Stromflusses angepasst werden.

An dieser Stelle sei angemerkt, dass der erste Anschluss der Schalteinrichtung und das erste Verbindungselement gemeinsam auch einteilig ausgebildet sein können und dass der zweite Anschluss der Schalteinrichtung und zweite Verbindungselement gemeinsam auch einteilig ausgebildet sein können.

Gegenstand der vorliegenden Erfindung ist auch ein Verfahren zur Herstellung eines Batteriemoduls mit einer Mehrzahl an gemäss dem unabhängigen Anspruch 9. Die Batteriezellen sind dabei insbesondere als Lithium-Ionen-Batteriezellen ausgebildet. Zudem sind die Batteriezellen jeweils elektrisch leitend seriell und/oder parallel miteinander verschaltet.

Dabei wird ein erstes elektrisch leitend ausgebildetes Verbindungselement elektrisch leitend mit einem ersten Abschluss einer Schalteinrichtung und einem Spannungsabgriff einer endständig angeordneten Batteriezelle verbunden.

Dabei wird ein zweites elektrisch leitend ausgebildetes Verbindungselement elektrisch leitend mit einem zweiten Anschluss der Schalteinrichtung und einem Spannungsabgriff des Batteriemoduls verbunden.

Das erste Verbindungselement und/oder das zweite Verbindungselement werden weiterhin wärmeleitend in einer Aufnahme des Gehäuses des Batteriemoduls aufgenommen.

Insbesondere ist das Verfahren ein Verfahren zur Herstellung eines eben beschriebenen erfindungsgemäßen Batteriemoduls, sodass das erfindungsgemäße Verfahren auch für den im Zusammenhang dem erfindungsgemäßen Batteriemodul beschriebenen vorteilhaften Weiterbildungen weitergebildet werden kann.

### Kurze Beschreibung der Zeichnungen

Ausführungsbeispiele der Erfindung sind in den Zeichnungen dargestellt und in der nachfolgenden Beschreibung näher erläutert.

### Es zeigt:

- Figur 1: einen Ausschnitt einer ersten erfindungsgemäßen Ausführungsform eines Batteriemoduls in einer perspektivischen Ansicht,
- Figur 2a: einen Ausschnitt der ersten erfindungsgemäßen Ausführungsform des Batteriemoduls auf ein erstes Verbindungselement,
- Figur 2b: einen Ausschnitt der ersten erfindungsgemäßen Ausführungsform des Batteriemoduls auf ein zweites Verbindungselement,
- Figur 3a: eine Anordnung eines Halteelements,
- Figur 3b: einen Ausschnitt der ersten erfindungsgemäßen Ausführungsform des Batteriemoduls auf das Halteelement,
- Figur 4: einen Ausschnitt einer zweiten erfindungsgemäßen Ausführungsform eines Batteriemoduls in einer perspektivischen Ansicht,
- Figur 5: einen Ausschnitt der zweiten erfindungsgemäßen Ausführungsform des Batteriemoduls auf ein Verbindungselement und
- Figur 6a: ein Halteelement,
- Figur 6b: einen Ausschnitt der zweiten erfindungsgemäßen Ausführungsform des Batteriemoduls auf das Halteelement,

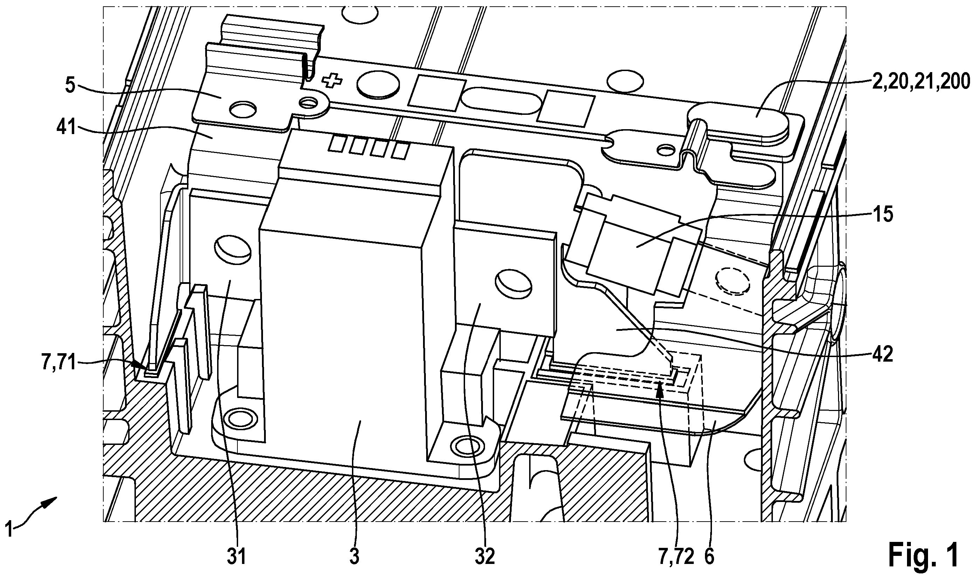

Figur 1 zeigt einen Ausschnitt einer ersten erfindungsgemäßen Ausführungsform eines Batteriemoduls 1 in einer perspektivischen Ansicht.

Das Batteriemodul 1 umfasst eine Mehrzahl an Batteriezellen 2, von denen in der Figur 1 exemplarisch eine Batteriezelle 2 gezeigt ist. Die Batteriezellen 2 sind dabei insbesondere als Lithium-Ionen-Batteriezellen 20 ausgebildet. Zudem sind die Batteriezellen 2 als prismatische Batteriezellen 200 ausgebildet. Die in der Figur 1 zu erkennende Batteriezelle 2 ist dabei insbesondere eine endständig angeordnete Batteriezelle 21.

Dabei sind die Batteriezellen 2 jeweils elektrisch leitend seriell und/oder parallel miteinander verschaltet.

Weiterhin umfasst das Batteriemodul 1 eine Schalteinrichtung 3. Die Schalteinrichtung 3 weist einen ersten Anschluss 31 und einen zweiten Anschluss 32 auf. Zudem umfasst das Batteriemodul 1 ein erstes Verbindungselement 41 und ein zweites Verbindungselement 42. Das erste Verbindungselement 41 und das zweite Verbindungselement 42 sind dabei jeweils elektrisch leitend ausgebildet. Das erste Verbindungselement 41 verbindet den ersten Anschluss 31 der Schalteinrichtung 3 elektrisch leitend mit einem Spannungsabgriff 5 der endständig angeordneten Batteriezelle 21.

Das zweite Verbindungselement 42 verbindet den zweiten Anschluss 32 der Schalteinrichtung 3 elektrisch leitend mit einem Spannungsabgriff 6 des Batteriemoduls 1.

Das erste Verbindungselement 41 und das zweite Verbindungselement 42 sind dabei aus Kupfer oder aus Aluminium oder aus einer Keramik ausgebildet.

Weiterhin umfasst ein Gehäuse 10 das Batteriemodul 1 Aufnahmen 7. Insbesondere weist das Batteriemodul 1 eine erste Aufnahme 71 und eine zweite Aufnahme 72 auf.

Dabei ist das erste Verbindungselement 41 wärmeleitend in der ersten Aufnahme 71 aufgenommen. Weiterhin ist das zweite Verbindungselement 42 wärmeleitend in der zweiten Aufnahme 72 aufgenommen.

Ferner umfasst das Batteriemodul 1 eine Sicherung 15, welche innerhalb des zweiten Verbindungselements 42 zwischen den zweiten Anschluss 32 und dem Spannungsabgriff 6 des Batteriemoduls 1 angeordnet ist. Alternativ könnte die Sicherung 15 auch zwischen dem zweiten Verbindungselement 42 und dem Spannungsabgriff 6 des Batteriemoduls 1 angeordnet sein.

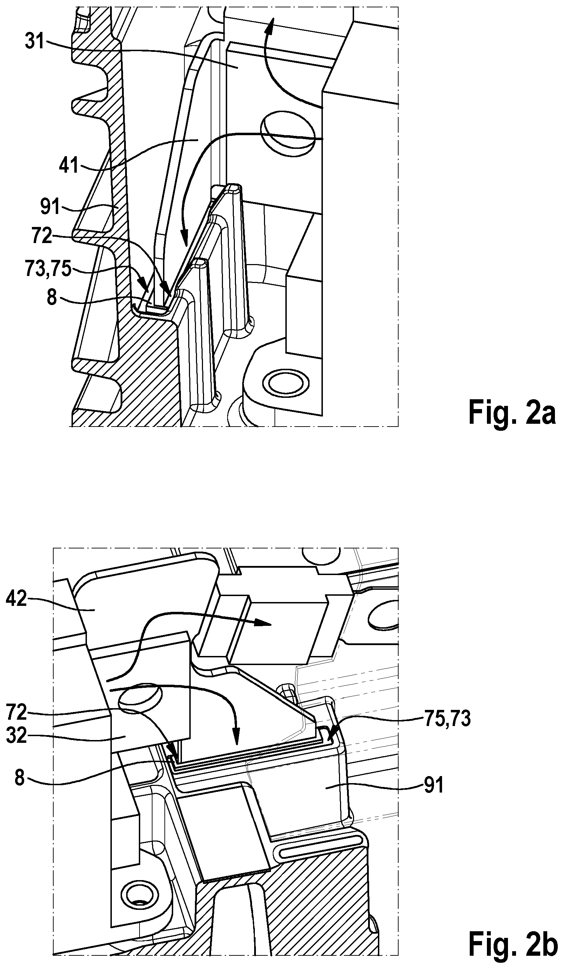

Die Figur 2a zeigt einen Ausschnitt der ersten erfindungsgemäßen Ausführungsform des Batteriemoduls 1 auf ein erstes Verbindungselement 41.

Dabei ist neben dem ersten Anschluss 31 der Schalteinrichtung 3 und dem ersten Verbindungselement 41 auch die erste Aufnahme 71 des Gehäuses 10 des Batteriemoduls 1 zu erkennen.

Weiterhin ist zu erkennen, dass in der ersten Aufnahme 71 ein wärmeleitend ausgebildetes Ausgleichsmaterial 8 angeordnet ist.

Die erste Aufnahme 71 ist dabei an einer Seitenfläche 91 des Gehäuses 10 des Batteriemoduls 1 ausgebildet. Die erste Aufnahme 71 weist dabei eine Öffnung 73 auf, welche eine Querschnittsfläche 75 aufweist, die senkrecht zu der Seitenfläche 91 angeordnet ist.

Die Figur 2b zeigt einen Ausschnitt der ersten erfindungsgemäßen Ausführungsform des Batteriemoduls 1 auf ein zweites Verbindungselement 42.

Dabei ist neben dem zweiten Anschluss 32 der Schalteinrichtung 3 und dem zweiten Verbindungselement 42 auch die zweiten Aufnahme 72 des Gehäuses 10 des Batteriemoduls 1 zu erkennen.

Weiterhin ist zu erkennen, dass in der zweiten Aufnahme 72 ein wärmeleitend ausgebildetes Ausgleichsmaterial 8 angeordnet ist.

Die zweite Aufnahme 72 ist dabei an einer Seitenfläche 91 des Gehäuses 10 des Batteriemoduls 1 ausgebildet. Die zweite Aufnahme 72 weist dabei eine Öffnung 73 auf, welche eine Querschnittsfläche 75 aufweist, die senkrecht zu der Seitenfläche 91 angeordnet ist.

Sowohl in der Figur 2a als auch in der Figur 2b sind durch die Pfeile mögliche Wärmeströme bei einer Entwärmung der Schalteinrichtung 3 eingetragen.

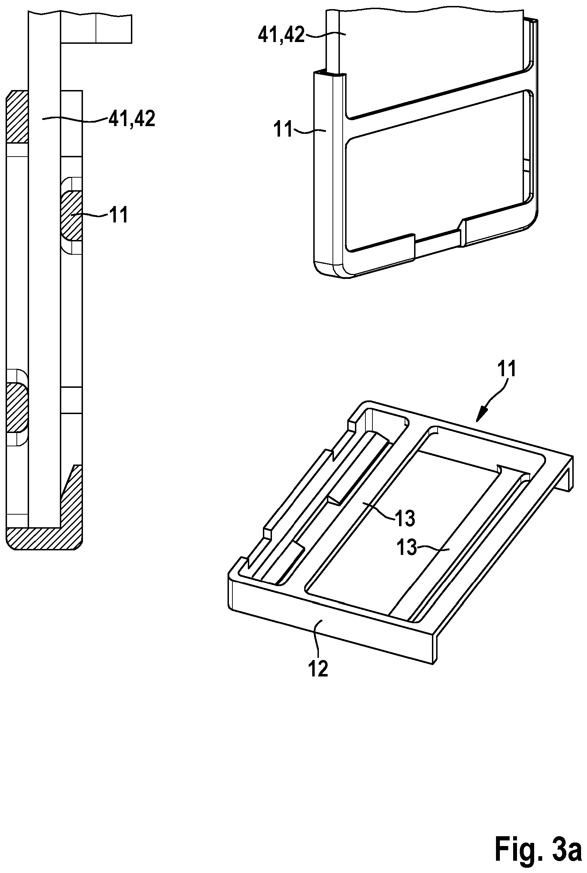

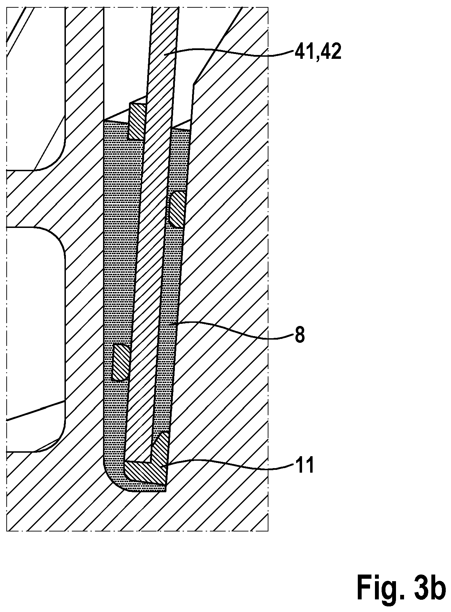

Figur 3a zeigt eine Anordnung eines Halteelements 11 und die Figur 3b zeigt einen Ausschnitt der ersten erfindungsgemäßen Ausführungsform des Batteriemoduls 1 auf ein Halteelement 11.

In der Figur 3a ist dabei zunächst das Halteelement 11 als solches zu erkennen. Weiterhin ist die Anordnung des Halteelements 11 an einem ersten Verbindungselement 41 bzw. einem zweiten Verbindungselement 42 in einer perspektivischen Ansicht und in einer Schnittansicht von der Seite zu erkennen.

Dabei kann das Halteelement 11 beispielsweise an dem ersten Verbindungselement 41 bzw. dem zweiten Verbindungselement 42 mittels einer Clipsverbindung befestigt sein. Das Halteelement 11 umfasst insbesondere einen Rahmen 12, welcher das erste Verbindungselement 41 bzw. das zweite Verbindungselement 42 zumindest teilweise an Längskanten und an einer Unterkante umläuft. Ferner umfasst das Halteelement 11 Abstandselemente 13, welche dazu dienen einen Abstand zwischen dem ersten Verbindungselement 41 bzw. dem zweiten Verbindungselement 42 und der jeweiligen Aufnahme 7, 71, 72 auszubilden.

In der Figur 3b ist eine Anordnung des ersten Verbindungselements 41 bzw. des zweiten Verbindungselements 42 und des Halteelements 11 in der Aufnahme 7 zu erkennen. Dabei ist zu erkennen, dass das Halteelement 11 bzw. die Abstandselemente 12 einen solchen Abstand erzeugen, dass das Ausgleichselement 8 innerhalb der Aufnahme 7 zwischen dem ersten Verbindungselement 41 bzw. dem zweiten Verbindungselement 42 und der Aufnahme 7 aufgenommen werden kann. Um eine optimale Anbindung durch das Ausgleichsmaterial 8 zu erhalten, kann das erste Verbindungselement 41 bzw. das zweite Verbindungselement 42 und auch das Halteelement 11 an die Aufnahme 7 angepasst sein. Dadurch kann eine effiziente Wärmeabfuhr zur Verfügung gestellt werden.

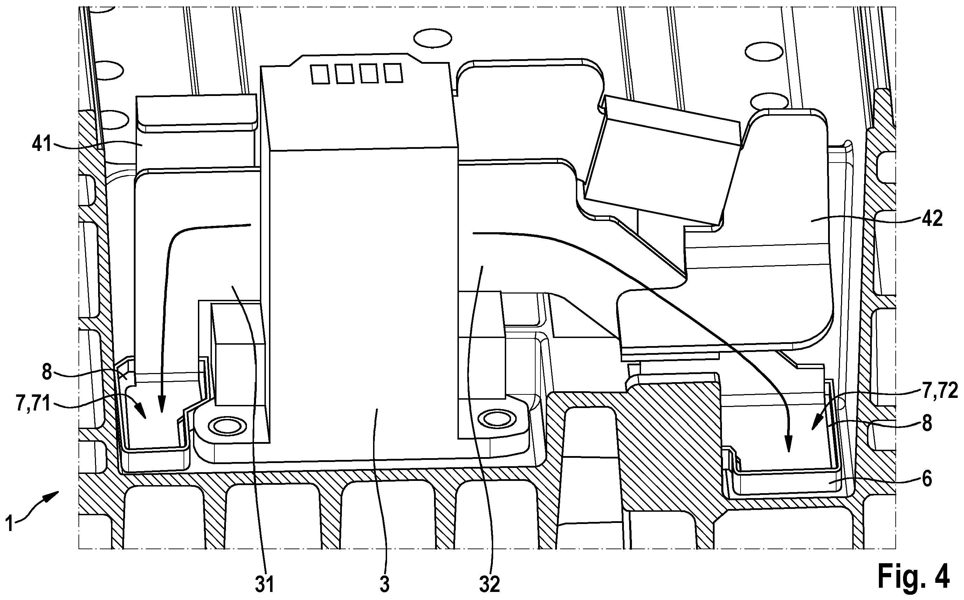

Figur 4 zeigt einen Ausschnitt einer zweiten erfindungsgemäßen Ausführungsform eines Batteriemoduls 1 in einer perspektivischen Ansicht.

Die in der Figur 4 gezeigte zweite Ausführungsform des Batteriemoduls 1 entspricht im Wesentlichen der bereits beschriebenen ersten Ausführungsform des Batteriemoduls 1. Ein Unterschied bspw. besteht in der wärmeleitenden Aufnahme zwischen des ersten Verbindungselements 41 in der ersten Aufnahme 71 sowie in der wärmeleitenden Aufnahme des zweiten Verbindungselements 42 in der zweiten Aufnahme 72.

Dabei umfasst auch bei der zweiten Ausführungsform des Batteriemoduls 1 das Gehäuse 10 des Batteriemoduls 1 Aufnahmen 7. Insbesondere weist das Batteriemodul 1 eine erste Aufnahme 71 und eine zweite Aufnahme 72 auf.

Dabei ist das erste Verbindungselement 41 wärmeleitend in der ersten Aufnahme 71 aufgenommen. Weiterhin ist das zweite Verbindungselement 42 wärmeleitend in der zweiten Aufnahme 72 aufgenommen.

In der Figur 4 sind durch die Pfeile mögliche Wärmeströme bei einer Entwärmung eingetragen.

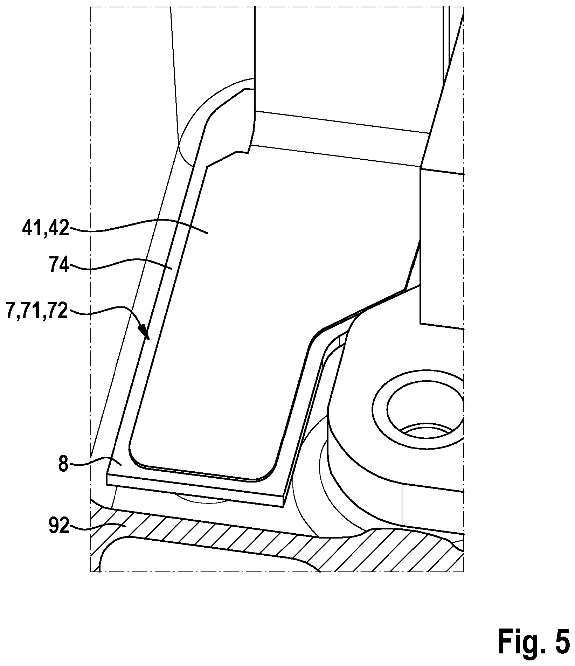

Die Figur 5 zeigt einen Ausschnitt der zweiten erfindungsgemäßen Ausführungsform des Batteriemoduls 1 auf ein erstes Verbindungselement 41 bzw. ein zweites Verbindungselement 42.

Dabei ist weiterhin die Aufnahme 7 bzw. die erste Aufnahme 71 oder die zweite Aufnahme 72 zu erkennen.

Die Aufnahme 7 ist dabei an einer Bodenfläche 92 des Gehäuses 10 des Batteriemoduls 1 ausgebildet. Die Aufnahme 7 weist dabei eine Öffnung 74 auf, welche eine Querschnittsfläche 76 aufweist, die parallel zu der Bodenfläche 92 angeordnet ist.

Weiterhin ist zu erkennen, dass in der zweiten Aufnahme 72 ein wärmeleitend ausgebildetes Ausgleichsmaterial 8 angeordnet ist.

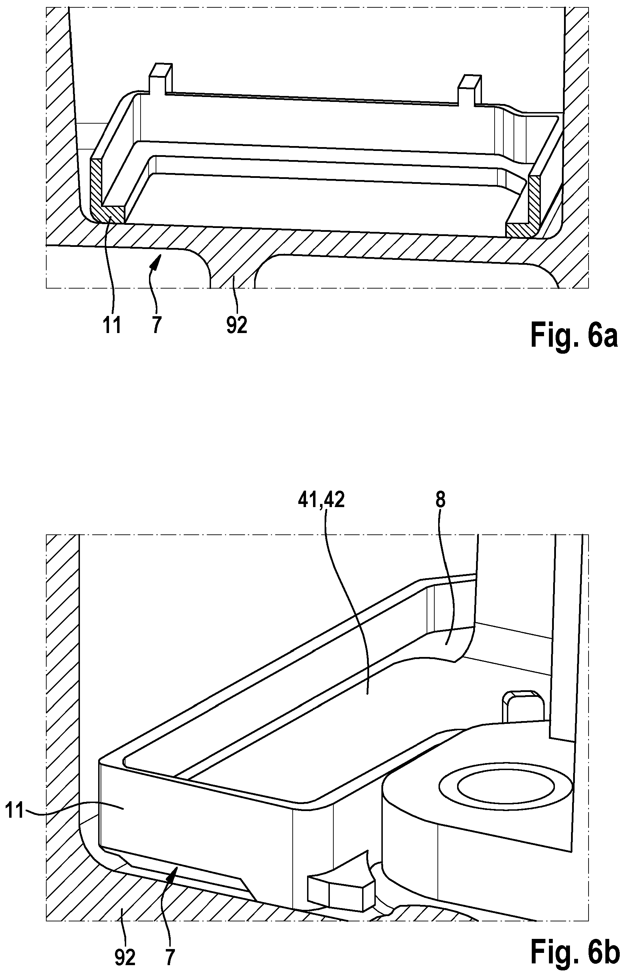

Die Figur 6a zeigt ein Halteelement 11 und Figur 6b zeigt einen Ausschnitt der zweiten erfindungsgemäßen Ausführungsform des Batteriemoduls 1 auf ein Halteelement 11.

Dabei ist zunächst das Halteelement 11 an der Bodenfläche 92 des Gehäuses 10 des Batteriemoduls 1 zu erkennen, und zwar bevor das erste Verbindungselement 41 bzw. das zweite Verbindungselement 42 angeordnet worden ist. Das Halteelement 11 kann dabei aus einem polymeren Werkstoff ausgebildet sein. Beispielseite kann das Halteelement 11 in der Figur 6a nicht zu erkennende Rippen aufweisen, welche dazu dienen das Halteelement 11 in der Aufnahme 7 des Gehäuses 10 des Batteriemoduls 1 zu zentrieren. Solche Rippen ermöglichen eine Ausrichtung und ermöglichen insbesondere eine vereinfachte Montage.

Die Figur 6b zeigt, dass das erste Verbindungselement 41 oder das zweite Verbindungselement 42 in der Aufnahme 7 angeordnet ist. Insbesondere ist das erste Verbindungselement 41 bzw. der zweite Verbindungselement 42 in dem Halteelement 11 aufgenommen. Weiterhin ist das Ausgleichselement 8 zu erkennen.

Das Halteelement 11 dient insbesondere zu einer zuverlässigen elektrischen Isolation des ersten Verbindungselements 41 bzw. des zweiten Verbindungselements 42 gegenüber der Aufnahme 7.

## Patentansprüche

1. Batteriemodul mit einer Mehrzahl an prismatisch ausgebildeten Batteriezellen (2), insbesondere Lithium-Ionen-Batteriezellen (20), welche jeweils elektrisch leitend seriell und/oder parallel miteinander verschaltet sind, und einer Schalteinrichtung (3), welche unmittelbar benachbart zu einer endständig angeordneten Batteriezelle angeordnet ist, und welche einen ersten Anschluss (31) und einen zweiten Anschluss (32) aufweist, wobei ein erstes elektrisch leitend ausgebildetes Verbindungselement (41) den ersten Anschluss (31) elektrisch leitend mit einem Spannungsabgriff (5) einer endständig angeordneten Batteriezelle (2, 21) verbindet und ein zweites elektrisch leitend ausgebildetes Verbindungselement (42) den zweiten Anschluss (32) elektrisch leitend mit einem Spannungsabgriff (6) des Batteriemoduls (1) verbindet,
**dadurch gekennzeichnet, dass**
das erste Verbindungselement (41) und/oder das zweite Verbindungselement (42) wärmeleitend in einer Aufnahme (7, 71, 72) des Gehäuses (10) des Batteriemoduls (1) aufgenommen sind.

2. Batteriemodul nach dem vorhergehenden Anspruch 1,
**dadurch gekennzeichnet, dass**
in der Aufnahme (7) ein wärmeleitend ausgebildetes Ausgleichsmaterial (8) aufgenommen ist.

3. Batteriemodul nach einem der vorhergehenden Ansprüche 1 bis 2,
**dadurch gekennzeichnet, dass**
die Aufnahme (7) an einer Seitenfläche (91) des Gehäuse (10) des Batteriemoduls (1) ausgebildet ist oder dass
die Aufnahme (7) an einer Bodenfläche (92) des Gehäuses (10) des Batteriemoduls (1) ausgebildet ist

4. Batteriemodul nach dem vorhergehenden Anspruch 3,
**dadurch gekennzeichnet, dass**
die Aufnahme (7) eine Öffnung (73, 74) mit einer
senkrecht zu der Seitenfläche (91) bzw. parallel zu der Bodenfläche (92) angeordneten Querschnittsfläche (75, 76) ausweist.

5. Batteriemodul nach einem der vorgehenden Ansprüche 1 bis 4
**dadurch gekennzeichnet, dass**
das Batteriemodul (1) weiterhin ein Halteelement (11) umfasst, welches zwischen der Aufnahme (7) und dem ersten Verbindungselement (41) bzw. zwischen der Aufnahme (7) und dem zweiten Verbindungselement (42) angeordnet ist.

6. Batteriemodul nach einem der vorgehenden Ansprüche 1 bis 5,
**dadurch gekennzeichnet, dass**
das erste Verbindungselement (41) und das zweite Verbindungselement (42) aus einem Werkstoff ausgewählt aus Kupfer oder Aluminium oder Keramik ausgebildet sind.

7. Batteriemodul nach einem der vorhergehenden Ansprüche 1 bis 6,
**dadurch gekennzeichnet, dass**
das Gehäuse (10) des Batteriemoduls (1) ein Temperierelement umfasst.

8. Batteriemodul nach dem vorhergehenden Anspruch 7,
**dadurch gekennzeichnet, dass**
die Aufnahme (7) unmittelbar benachbart zu dem Temperierelement angeordnet ist.

9. Verfahren zur Herstellung eines Batteriemoduls
mit einer Mehrzahl an prismatisch ausgebildeten Batteriezellen (2), insbesondere Lithium-Ionen-Batteriezellen (20), welche jeweils elektrisch leitend seriell und/oder parallel miteinander verschaltet sind, wobei ein erstes elektrisch leitend ausgebildetes Verbindungselement (41) elektrisch leitend mit einem ersten Anschluss (31) einer Schalteinrichtung (3) und einem Spannungsabgriff (5) einer endständig angeordneten Batteriezelle (2, 21) verbunden wird, und
wobei ein zweites elektrisch leitend ausgebildetes Verbindungselement (42) elektrisch leitend mit einem zweiten Anschluss (32) der Schalteinrichtung (3) und einem Spannungsabgriff (6) des Batteriemoduls (1) verbunden wird, wobei die Schalteinrichtung unmittelbar benachbart zu einer endständig angeordneten Batteriezelle angeordnet wird,
**dadurch gekennzeichnet, dass**
das erste Verbindungselement (41) und/oder das zweite Verbindungselement (42) wärmeleitend in einer Aufnahme (7, 71, 72) des Gehäuses (10) des Batteriemoduls (1) aufgenommen werden.

## Claims

1. Battery module comprising a plurality of prismatic battery cells (2), in particular lithium-ion battery cells (20), which
are each electrically conductively interconnected with each other in series and/or in parallel, and a switching device (3), which is arranged directly adjacent to a terminal battery cell and which
has a first connection (31) and a second connection (32), wherein a first electrically conductive connecting element (41)
electrically conductively connects the first connection (31) to a voltage tap (5) of a terminal battery cell (2, 21) and
a second electrically conductive connecting element (42)
electrically conductively connects the second connection (32) to a voltage tap (6) of the battery module (1),
**characterized in that**
the first connecting element (41) and/or the second connecting element (42) are thermally conductively received in a receptacle (7, 71, 72) of the housing (10) of the battery module (1).

2. Battery module according to preceding Claim 1,
**characterized in that**
a thermally conductive compensating material (8) is received in the receptacle (7).

3. Battery module according to either of preceding Claims 1 and 2,
**characterized in that**
the receptacle (7) is formed on a side surface (91) of the housing (10) of the battery module (1), or **in that**
the receptacle (7) is formed on a base surface (92) of the housing (10) of the battery module (1).

4. Battery module according to preceding Claim 3,
**characterized in that**
the receptacle (7) has an opening (73, 74) with a
cross-sectional area (75, 76) arranged perpendicular to the side surface (91) and parallel to the base surface (92).

5. Battery module according to any of preceding Claims 1 to 4,
**characterized in that**
the battery module (1) further comprises a holding element (11) which is arranged between the receptacle (7) and the first connecting element (41) or between the receptacle (7) and the second connecting element (42).

6. Battery module according to any of preceding Claims 1 to 5,
**characterized in that**
the first connecting element (41) and the second connecting element (42) are made of a material selected from copper or aluminium or ceramic.

7. Battery module according to any of preceding Claims 1 to 6,
**characterized in that**
the housing (10) of the battery module (1) comprises a temperature-control element.

8. Battery module according to preceding Claim 7,
**characterized in that**
the receptacle (7) is arranged directly adjacent to the temperature-control element.

9. Method for producing a battery module
comprising a plurality of prismatic battery cells (2), in particular lithium-ion battery cells (20), which
are each electrically conductively interconnected with each other in series and/or in parallel, wherein a first electrically conductive connecting element (41) is electrically conductively connected to a first connection (31) of a switching device (3) and a voltage tap (5) of a terminal battery cell (2, 21), and
wherein a second electrically conductive connecting element (42) is electrically conductively connected to a second connection (32) of the switching device (3) and a voltage tap (6) of the battery module (1),
wherein the switching device is arranged directly adjacent to a terminal battery cell,
**characterized in that**
the first connecting element (41) and/or the second connecting element (42) are/is thermally conductively received in a receptacle (7, 71, 72) of the housing (10) of the battery module (1).

## Revendications

1. Module de batterie comportant une pluralité de cellules de batterie (2) de forme prismatique, en particulier des cellules de batterie lithium-ion (20), lesquelles
sont connectées électriquement les unes aux autres en série et/ou en parallèle, et un dispositif de commutation (3) qui est disposé de manière directement adjacente à une cellule de batterie disposée à l'extrémité, et qui
comporte une première borne (31) et une deuxième borne (32), un premier élément de connexion (41) électriquement conducteur
reliant électriquement la première borne (31) à une prise de tension (5) d'une cellule de batterie (2, 21) disposée à l'extrémité, et
un deuxième élément de connexion (42) électriquement conducteur reliant électriquement la deuxième borne (32) à une prise de tension (6) du module de batterie (1),
**caractérisé en ce que**
le premier élément de connexion (41) et/ou le deuxième élément de connexion (42) sont logés de manière thermoconductrice dans un logement (7, 71, 72) du boîtier (10) du module de batterie (1).

2. Module de batterie selon la revendication 1 précédente,
**caractérisé en ce**
**qu'**une matière de compensation réalisée de manière thermoconductrice (8) est logée dans le logement (7).

3. Module de batterie selon l'une des revendications 1 à 2 précédentes, **caractérisé en ce que**
le logement (7) est réalisé sur une face latérale (91) du boîtier (10) du module de batterie (1) ou **en ce que**
le logement (7) est réalisé sur une surface inférieure (92) du boîtier (10) du module de batterie (1).

4. Module de batterie selon la revendication 3 précédente,
**caractérisé en ce que**
le logement (7) présente une ouverture (73, 74) ayant une section transversale (75, 76) disposée perpendiculairement à la face latérale (91) ou parallèlement à la surface inférieure (92).

5. Module de batterie selon l'une des revendications 1 à 4 précédentes,
**caractérisé en ce que**
le module de batterie (1) comprend en outre un élément de retenue (11) disposé entre le logement (7) et le premier élément de connexion (41) ou entre le logement (7) et le deuxième élément de connexion (42).

6. Module de batterie selon l'une des revendications 1 à 5 précédentes,
**caractérisé en ce que**
le premier élément de connexion (41) et le deuxième élément de connexion (42) sont réalisés à partir d'un matériau choisi parmi le cuivre, l'aluminium ou une céramique.

7. Module de batterie selon l'une des revendications 1 à 6 précédentes,
**caractérisé en ce que**
le boîtier (10) du module de batterie (1) comprend un élément de régulation de température.

8. Module de batterie selon la revendication 7 précédente,
**caractérisé en ce que**
le logement (7) est disposé de manière directement adjacente à l'élément de régulation de température.

9. Procédé de fabrication d'un module de batterie
comportant une pluralité de cellules de batterie (2) de forme prismatique, en particulier des cellules de batterie lithium-ion (20), lesquelles
sont connectées électriquement les unes aux autres en série et/ou en parallèle, un premier élément de connexion (41) électriquement conducteur étant relié électriquement à une première borne (31) d'un dispositif de commutation (3) et à une prise de tension (5) d'une cellule de batterie (2, 21) disposée à l'extrémité, et
un deuxième élément de connexion (42) électriquement conducteur étant relié électriquement à une deuxième borne (32) du dispositif de commutation (3) et à une prise de tension (6) du module de batterie (1),
le dispositif de commutation étant disposé de manière directement adjacente à une cellule de batterie disposée à l'extrémité,
**caractérisé en ce que**
le premier élément de connexion (41) et/ou le deuxième élément de connexion (42) sont logés de manière thermoconductrice dans un logement (7, 71, 72) du boîtier (10) du module de batterie (1).
